(19) Europäisches Patentamt
European Patent Office
Office européen des brevets

(11) **EP 3 370 310 A1**

(12) **EUROPEAN PATENT APPLICATION**

(43) Date of publication:
**05.09.2018 Bulletin 2018/36**

(51) Int Cl.:
*H01S 5/10* (2006.01)   *H01S 5/06* (2006.01)

(21) Application number: **17158685.2**

(22) Date of filing: **01.03.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Technische Universität München**
**80333 München (DE)**

(72) Inventors:
• **Demmerle, Frederic**
**80333 München (DE)**

• **Oberhausen, Wolfhard**
**80939 München (DE)**
• **Amann, Markus-Christian**
**80935 München (DE)**
• **Burghart, Dominik**
**81245 München (DE)**

(74) Representative: **Lucke, Andreas**
**Boehmert & Boehmert**
**Anwaltspartnerschaft mbB**
**Pettenkoferstrasse 22**
**80336 München (DE)**

(54) **COMBINED MIR AND THZ OPTICAL GRATING FOR VERTICAL THZ EMISSION IN DFG-QCLS**

(57)    A light source for generating light of a predefined wavelength, comprising a waveguide structure (10) defining a propagation direction of light, wherein said waveguide structure (10) comprises an active region (12) comprising a gain medium for amplifying light within said waveguide structure (10), and a non-linear medium suitable for generating light of the predefined wavelength from light of a first wavelength and from light of a second wavelength by means of difference frequency generation or sum frequency generation. The waveguide structure (10) further comprises a first optical grating (14) and a second optical grating (16). The first optical grating (14) is configured to ensure lasing of the first wavelength and of the second wavelength and to suppress lasing at any other wavelength to thereby generate light of said first wavelength and light of said second wavelength, wherein said first optical grating (14) is further configured to determine a first spatial phase relationship of the light of the first wavelength, and a second spatial phase relationship of the light of the second wavelength. The second optical grating (16) is configured for extracting light of the predefined wavelength out of the waveguide structure (10) in an extraction direction substantially perpendicular to the propagation direction, wherein the second optical grating (16) is arranged relative to the first optical grating (14) such that a constructive interference of the light of said predefined wavelength in the far field is provided.

Fig. 2

**Description**

FIELD OF THE INVENTION

The present invention is in the field of light generation with semiconductor lasers. In particular, the present invention relates to a light source for generating light of a predefined wavelength, to a method of generating light of a predefined wavelength, and to a method of manufacturing a light source. In cases of special interest, the aforesaid predefined wavelength is in the THz range and the light source corresponds to a quantum cascade laser (QCL).

BACKGROUND OF THE INVENTION

Light in the The range is a long-wave, non-ionising and hence non-dangerous type of light that is increasingly being used in numerous applications in the fields of spectroscopy, imaging and biological engineering. Many materials have a very specific spectrum in the THz range which can be of use for the characterisation and the analysis thereof. Some materials like paper, plastic or ceramic are transparent to THz radiation, while other materials such as water or metals are not. Therefore, THz images may be a very good complement for x-ray images and optical images. For these reasons, the generation of light in the THz spectral range is a subject of interest. However, cost effective, reasonably sized and widely tunable light sources for generating light in the THz range are not yet available.

Quantum cascade lasers (QCLs) reveal themselves as a promising technology for the generation of light in the THz range, particularly due to their versatility, ease of integration and operating simplicity. However, quantum cascade lasers generally require operation at very low temperatures for the direct generation of light in the THz range. The only know way to generate THz light with QCLs at room temperature is the use of difference frequency generation, which, like sum frequency generation, is a non-linear optical process in which light of two different wavelengths interacts in a medium having a second-order non-linear susceptibility, to produce light at frequencies corresponding respectively to the difference or the sum of the two different wavelengths, respectively.

When light of a desired wavelength, for example a wavelength in the THz range, is generated with a quantum cascade laser, a technical difficulty to be overcome is the "extraction" of said light from the corresponding laser device such as to render it usable for other purposes outside of the device. The extraction consists in a process or mechanism allowing light of the aforesaid desired wavelength generated inside of a device to be directed in a controlled way towards the exterior of the device. Known solutions are either based on the Cherenkov phase matching scheme or on the so-called vertical extraction.

The Cherenkov phase matching scheme is based on Cherenkov emission, which occurs when the non-linear polarization wave has a phase velocity within a non-linear optical material that is larger than the phase velocity of the radiation generated in a medium surrounding the non-linear optical material. In this case, the generated radiation is emitted at the so-called Cherenkov angle and can be extracted from the material, typically through a polished facet,

The Cherenkov phase matching scheme comes with a number of important drawbacks. For one thing, differences between the efficiency of the extraction of THz waves generated close to the facet, which are extracted almost completely, and THz waves generated far away from the facet, which are subject to increasing absorption losses, give rise to an undesired geometric dependence of the extraction, since light generated inside a device can only be extracted in an efficient way within a limited region of the device close to the facet. Further, the extraction of THz waves through the facet is geometrically limited by the thickness and the length of the material in which the THz waves are generated. There is a critical length of the material above which generated THz waves experience multiple reflection in the material and are almost completely lost by absorption,

An alternative approach consists in the vertical extraction of the THz waves through an upper surface of a device comprising a non-linear optical material by means of an optical grating, However, such solutions do not achieve a degree of efficiency comparable to that obtainable with the Cherenkov phase matching scheme.

In view of the above, there is room for technical improvements in the generation and the extraction of electromagnetic radiation, particularly in the THz range, by means of light source devices based on non-linear optical effects like difference frequency generation and sum frequency generation.

SUMMARY OF THE INVENTION

The problem underlying the invention is to provide means and methods for generating light of a predefined wavelength with a light source at room temperature and for extracting said light of a predefined wavelength from the light source with an improved efficiency as compared to previously existing solutions, wherein a high efficiency herein implies a minimization of losses in the extraction of the generated light for practical use. This problem is solved by a light source for generating light of a predefined wavelength according to claim 1, a method of generating light of a predefined wavelength according to claim 12 and a method of manufacturing a light source according to claim 14. Herein a "light source" refers to a device suitable for generating light of a predefined wavelength. "Light" refers in the context of the present invention to electromagnetic radiation in general, i.e. to electro-magnetic waves of any wavelength. "Wavelength" refers herein to the wavelength value for light propagating freely in vacuum in the case of the light of the predefined wavelength, whereas in the case of the first wavelength and of the second wavelength, "wavelength" refers - unless stated otherwise - to the wavelength value of light propagating within the waveguide structure. It is known that light experiences a change in the wavelength - not in frequency - when transiting from a transmission medium to another transmission medium having a different index of refraction. For example, the value of the wavelength may change when light transits from vacuum to a waveguide or vice versa. Values may then be converted into each other by taking into account the value of the effective refraction index of the corresponding transmission media, e.g. of vacuum and of the aforesaid waveguide as known to the skilled person. The structure and function of the light source of the present invention may correspond to that of a laser, in particular to that of a quantum cascade laser, although other kinds of light sources are foreseen in the invention as well. Preferable embodiments of the invention are described in the dependent claims.

The light source of the invention comprises a waveguide structure defining a propagation direction of light. Herein, a "waveguide structure" refers to a structure configured for guiding electromagnetic waves such that electro-magnetic waves can propagate through the waveguide structure along one or two dimensions thereof with a negligible energy loss. The waveguide structure comprises an active region, which is a region of the waveguide that comprises a gain medium for amplifying light within the waveguide structure and a non-linear medium suitable for generating light of the predefined wavelength from light of a first wavelength and from light of a second wavelength by means of difference frequency generation or sum frequency generation. In the following, the aforementioned "light of the predefined wavelength" is also referred to as "extraction light" for simplicity, since it is the light that is eventually to be extracted from the device for practical use. This ought not to be confused with "extracted light", which refers to the light that is actually extracted from the device.

A "gain medium" refers herein to a medium suitable in terms of any of purity, size, concentration, and shape for amplifying light by means of stimulated emission. A "non-linear medium" refers herein to a medium exhibiting a non-linear optical behaviour, in particular a medium having a relatively large second-order non-linear susceptibility. Such a second-order non-linear susceptibility allows for sum frequency generation (SFG) or difference frequency generation (DFG), where light of two wavelengths generate light having a frequency equal to the sum (SFG) or the difference (DFG) of the frequencies involved in the process, respectively.

The waveguide structure of the light source of the invention further comprises a first optical grating configured to ensure lasing of the first wavelength and of the second wavelength and to suppress lasing at any other wavelength to thereby generate light of the first wavelength and light of said second wavelength. The lasing may be understood as a process resulting on the one hand from amplified light being generated in the gain medium of the active region within a certain range of the spectrum, and on the other hand from the first optical grating interacting in a selective way with said amplified light, so that light of the first wavelength and light of the second wavelength are selected, i.e. lased, while the rest of the wavelengths of the light amplified by the gain medium is suppressed.

The first optical grating is further configured to determine a first spatial phase relationship of the light of the first wavelength and a second spatial phase relationship of the light of the second wavelength. "Spatial phase relationship" refers herein to a spatial distribution of the values of the amplitude of the electric field waves respectively corresponding to the light of the first wavelength and of the second wavelength over the extent of the waveguide structure along the propagation direction.

The first optical grating performs a selection of two wavelengths, i.e. the first wavelength and the second wavelength, from all wavelengths in the spectrum range amplified in the gain medium of the active region that are compatible with the geometry of the first optical grating. "Compatible" refers herein to the suitability of the first optical grating for determining the spatial phase relationships of the selected wavelengths. For instance, in preferred embodiments of the invention, the spatial phase relationships of the selected wavelengths may be determined by fixing the position of the nodes of the corresponding electric field waves in the waveguide structure. In these cases, the spatial arrangement of the first optical grating in the waveguide structure gives rise to light of the first wavelength and light of the second wavelength in the form of standing waves, that is, in the form of waves that oscillate in time, but have a spatial dependence that is stationary. This means that at any point in the waveguide structure along the propagation direction, the amplitude of the oscillations has a value that is constant in time. Said standing waves may for instance correspond, entirely or in part, to a superposition of a backward propagating wave and a forward propagating wave, wherein the backward propagating wave and the forward propagating wave are light waves of the first wavelength or of the second wavelength respectively propagating in opposite sense in the propagation direction.

For example, the light of the first wavelength at a given location of the waveguide structure may permanently have a given amplitude value, while the light of the second wavelength at said given location of the waveguide structure may permanently have an amplitude value other than said given amplitude value. This does not exclude, however, that the light of the first wavelength and the light of the second wavelength may have the same amplitude value at one or more locations within the waveguide structure. For example, both the light of the first wavelength and the light of the second wavelength have an amplitude value of zero at the nodes of the respective waves, whose position may be determined by the first optical grating.

The light of the first wavelength and the light of the second wavelength interact non-linearly in the active region of the waveguide structure due to the presence of the non-linear medium. In particular, the light of the first wavelength and the light of the second wavelength may interact by means of difference frequency generation and give rise to a polarization wave having a frequency that corresponds to the difference between the frequency of the light of the first wavelength and the frequency of the light of the second wavelength. While the invention is described herein with reference to difference frequency generation, it should be noted that the light of the first wavelength and the light of the second wavelength may as well interact by means of sum frequency generation and give rise to a polarization wave having a frequency that corresponds to the sum of the frequency of the light of the first wavelength and of the frequency of the light of the second wavelength.

A "polarization wave" refers herein to a wave of electric polarization in the non-linear medium that propagates therethrough due to non-linear optical effects. This polarization wave should not be confused with the polarization direction of the electromagnetic field itself, i.e. with the polarization direction of the light of the first wavelength or of the light of the second wavelength. A part of the polarization wave in the extraction direction may be generated by means of difference frequency generation, in which case the frequency of this part of the polarization wave corresponds to the difference of the frequency of the light of the first wavelength and the frequency of the light of the second wavelength. The polarization wave propagates through the waveguide structure in the propagation direction and emits light, i.e. electromagnetic radiation, at the same frequency as that of said part of the polarization wave, which in the case of difference frequency generation corresponds to the difference between the frequency of the light of the first wavelength and the frequency of the light of the second wavelength.

The polarization wave is given by the expression

$$P^{(2)}(x,y,z,t) = \varepsilon_0 \chi^{(2)}(x,y) E_{\omega_1}^x(x,y) E_{\omega_2}^x(x,y) e^{-i[(\omega_1-\omega_2)t-(k_1-k_2)z]} \qquad (1)$$

where $\varepsilon_0$ is the vacuum permittivity, $\chi^{(2)}$ is the non-linear susceptibility of the non-linear medium, z represents the propagation direction, x represents a direction perpendicular to the propagation direction, i.e. a direction parallel or approximately parallel to the extraction direction, and y is a direction perpendicular to x and to z. $E_{\omega_1}^x(x,y)$ and $E_{\omega_2}^x(x,y)$ are the components in the x-direction of the electric field amplitudes corresponding to the frequency $\omega_1$ of the light of the first wavelength and to the frequency $\omega_2$ of the light of the second wavelength respectively, which respectively have wave vectors of magnitude $k_1$ and $k_2$. Note that the phase term of the exponential factor indicates that the polarization wave is a wave having a frequency corresponding to the difference between the frequency of the light of the first wavelength and the frequency of the light of the second wavelength $\omega_1 - \omega_2$. In case the polarization wave has a part which is generated by sum frequency generation instead of difference frequency generation, the corresponding exponential factor takes the form $e^{-i[(\omega_1+\omega_2)t-(k_1+k_2)z]}$.

The configuration of the first optical grating determines the values of the first wavelength and of the second wavelength and hence the value of the predefined wavelength. Therefore, the configuration of the first optical grating may be chosen according to a desired value of the predefined wavelength. For example, if the predefined wavelength is to corresponds to frequencies in the THz range (e.g. between 1 THz and 6 THz), the values of the first wavelength and of the second wavelength should correspond to frequencies in the mid-infrared range (e.g. between 20 THz and 50 THz), and the first optical grating may be configured accordingly.

Thus, the first optical grating fulfils a two-fold function. On the one hand, the first optical grating provides a selection of the first wavelength and of the second wavelength from the wavelengths that may be present in the light amplified in the gain medium of the active region. This wavelength selection by the first optical grating contributes to a better efficiency of the extraction as well as to the reduction of parasitic modes in the extraction light. On the other hand, the first optical grating determines the spatial phase relationships of the light of the first wavelength and of the light of the second wavelength.

The waveguide structure further comprises a second optical grating configured for extracting light of the predefined wavelength out of the waveguide structure in an extraction direction substantially perpendicular to the propagation direction, wherein the second optical grating is arranged relative to the first optical grating such that a constructive interference of the light of said predefined wavelength in the far field is provided. The "far field" refers herein to a spatial region outside of the waveguide structure in which the extraction light propagates and which is at a distance from the waveguide structure that is large enough for the physical behaviour of the extraction light to be dominated by electric or magnetic fields with electric dipole characteristics. This is in contrast to the so-called "near field", in which the extraction light is governed by multipole type fields.

The extraction light corresponds to the light emitted by the polarization wave as it propagates through the waveguide structure. Since the polarization wave results from the interaction of the light of the first wavelength and of the light of the second wavelength via difference frequency generation, and the spatial phase relationships of the light of the first wavelength and of the light of the second wavelength are determined by the first optical grating, the spatial phase relationship of the polarization wave, and hence the spatial phase relationship of the extraction light as well, are determined by the first optical grating.

An appropriate arrangement of the second optical grating may allow benefiting from knowledge about the spatial phase relationship of the extraction light determined by the first optical grating in order to control the behaviour of the extraction light in the far field, that is, its behaviour once it has exited the waveguide structure. In other words, the spatial phase relationship of the light of the first wavelength and of the light of the second wavelength, which is defined by the first optical grating, may be used as a design criterion for the arrangement of the second optical grating which allows selectively controlling the far field behaviour of the extraction light. This is exploited to provide for a constructive interference of the extraction light in the far field in order to increase the efficiency of the extraction.

Thus, the invention achieves, through the functional combination of the first optical grating and of the second optical grating, the generation and the extraction of light of a predefined wavelength with an improved efficiency.

The extraction light may be employed for practical uses once it has exited the waveguide structure, for example for spectroscopy or scanner purposes. The increased efficiency in the extraction of the extraction light hence contributes to a more efficient and convenient use thereof, for instance in the context of the aforementioned exemplary uses. In particular, the increased extraction efficiency provided by the invention may allow for handier devices of a reduced size.

Further, the invention allows for an extraction of the light of the predefined wavelength from the waveguide structure in a way that is not subject to geometrical dependencies, as opposed to other solutions known from the prior art. Since the extraction light is extracted in a direction substantially perpendicular to the propagation direction, the extraction light may be extracted from the waveguide structure with an improved efficiency irrespectively of the location of the waveguide structure at which the extraction light is extracted and of the length and/or of the form of the waveguide structure, unlike e.g. in the case of extraction based on the Cherenkov phase matching. Further, the invention achieves notably higher extraction efficiency with respect to previously known solutions based on vertical extraction. These solutions usually suffer from the presence of parasitic modes in the extracted radiation and from limited efficiency. The present invention overcomes all mentioned problems thanks to the functional integration of the first optical grating and the second optical grating, making it possible to generate and extract light of a predefined wavelength at intensities that are not accessible to previously known solutions.

According to preferred embodiments of the invention, the extraction direction is perpendicular to the propagation direction, or is at an angle deviating from 90° with respect to the propagation direction by less than 25°, preferably by less than 15°.

In preferred embodiments of the invention, the first optical grating is index-coupled or gain/loss-coupled or complex-coupled with respect to the active region. "Index-coupled" refers herein to a first optical grating having a complex refraction index whose imaginary part is approximately equal to that of a refraction index of the active region, while the respective real parts may differ from one another. "Gain/loss-coupled" refers herein to a first optical grating having a complex refraction index whose real part is approximately equal to that of a refraction index of the active region, while the respective imaginary parts may differ from one another. "Complex coupled" refers herein to a first optical grating having a complex refraction index whose real and imaginary parts differ from those of the refraction index of the active region.

In preferred embodiments of the invention, the first optical grating is arranged on an upper surface of the active region or within the active region. An arrangement of the first optical grating on the upper surface of the active region provides the advantage of a simple technical implementation. An arrangement of the first optical grating within the active region provides the advantage of a more efficient wavelength selection function of the first optical grating.

In preferred embodiments of the invention, the first optical grating comprises one of a high order grating, a dual-section grating, and a modulated grating. A "high order grating" refers herein to a grating able to select wavelengths through the formation of standing waves in such a way that there is a plurality of nodes of said standing waves within each period of the high order grating. The first optical grating may preferably be a high order grating in cases in which the waveguide structure has a closed form. A "dual-section grating" refers herein to a grating comprising two sub-gratings that are spatially separated and respectively configured to select one wavelength. For instance, a dual-section grating may comprise a first sub-grating configured for selecting light of the first wavelength and a second sub-grating configured for selecting light of the second wavelength, wherein the first sub-grating is arranged within a first portion of the waveguide structure along the propagation direction and the second sub-grating is arranged within a second portion of the waveguide structure along the propagation direction. A "modulated grating" refers herein to a grating comprising two or more sub-gratings, wherein each of the two or more sub-gratings is arranged within the waveguide structure extending along the propagation direction and over the entire length of the waveguide structure, such that the modulated grating is suitable for simultaneously selecting two or more wavelengths. For instance, a modulated grating may comprise a first sub-grating configured for selecting light of the first wavelength and a second sub-grating configured for selecting light of the second wavelength, wherein both the first sub-grating and the second sub-grating are arranged within the waveguide structure along the propagation direction and extend over the whole length of the waveguide structure. In particular, the first sub-grating and the second sub-grating may be superimposed.

According to preferred embodiments of the invention, the first optical grating comprises an arrangement of one or more absorbing grating elements configured for fixing the spatial phase relationship of the light of the first wavelength and/or the spatial phase relationship of the light of the second wavelength. Hence, the first optical grating may be formed by such an arrangement of one or more absorbing grating elements. The absorbing grating elements may be configured for fixing the value of the amplitude of the light of the first wavelength and the value of the amplitude of the light of the second wavelength.

In preferred embodiments of the invention, the absorbing grating elements may fix the value of the amplitude of the light of the first wavelength and the value of the amplitude of the light of the second wavelength to be zero at those locations of the waveguide structure at which the one or more absorbing grating elements are arranged, such that the location of the nodes of the corresponding standing waves coincide with the locations of the absorbing grating elements.

In preferred embodiments of the invention, the arrangement of the absorbing grating elements in the waveguide structure along the propagation direction may be such that the first wavelength $\lambda_1$ and the second wavelength $\lambda_2$ to be selected by the first optical grating arc comprised within the range of the spectrum amplified by the gain medium of the active region, The arrangement of the absorbing grating elements in the waveguide structure along the propagation direction may then be characterised by a regular mutual distance. $\Lambda$ between two adjacent absorbing grating elements (i.e, a period of the first optical grating) that corresponds to a first integer multiple *m* of half the value of the first wavelength and to a second integer multiple *n* of half the value of the second wavelength wherein the first integer multiple and the second integer multiple are consecutive integer values, namely $\Lambda = m\frac{\lambda_1}{2} = n\frac{\lambda_2}{2}$, with *m = n + 1* and $m, n \in \mathbb{N}$.

This way, the lasing condition is ensured for the first wavelength and for the second wavelength only, for no other wavelength is amplified by the gain medium of the active region that would be compatible with the first optical grating. Note that the first wavelength and the second wavelength refer herein to the wavelength values of light propagating within the waveguide structure, that is, of the light of the first wavelength and of the light of the second wavelength. The corresponding equivalent values for light propagating freely in vacuum $\lambda_1^{vac}$ and $\lambda_2^{vac}$ can be obtained straightforwardly by properly taking into account the effective refraction index *N* experienced by light propagating within the waveguide structure $\lambda_i^{vac} = \lambda_i N$ with i=1 or 2, respectively.

In preferred embodiments of the invention, the second optical grating comprises one or more screening elements, wherein the screening elements are configured for selectively blocking the extraction of light of the predefined wavelength according to a spatial phase relationship of the light of the predefined wavelength. The screening elements preferably have a length that coincides with the mutual distance $\Lambda$ between two adjacent absorbing grating elements of the first optical grating. Preferably, each screening element of the second optical grating may extend between two adjacent absorbing grating elements of the first optical grating. According to this embodiment, the second optical grating selectively blocks the light field of the extraction light according to the phase relationship of the light of the predefined wavelength, such as to determine what part of the extraction light contributes to the constructive interference pattern in the far field according to said spatial phase relationship of the light of the predefined wavelength, which is indirectly determined by the first optical grating. "Light field" refers herein to the electric field component in the propagation direction corresponding to the extraction light. The constructive interference of the extraction light in the far field is hence formed by a part of the extraction light corresponding to the light field that is not blocked by the screening elements.

For instance, the screening elements may be arranged such as to block negative semi periods of the extraction light in which the electric field component of the extraction light in the extraction direction has an amplitude with a negative value, such that only semi periods of the extraction light in which the electric field component of the extraction light in the extraction direction has an amplitude with a positive value contribute to the interference pattern of the extraction light in the far field. This way, the totality of the extraction light that contributes to the interference pattern in the far field along the extent of the waveguide structure in the propagation direction has a positive amplitude, which guarantees a maximal constructive interference and hence a maximal efficiency of the extraction. The screening elements may block the corresponding part of the extraction light by absorbing and/or by reflecting said part of the extraction light.

According to a preferred embodiment of the invention, the screening elements are periodically arranged and the second optical grating has a duty cycle between 20% and 80%, preferably between 30% and 70%, and most preferably between 45% and 55%, wherein the duty cycle is defined as the ratio of a length of the screening elements over a distance between the centres of two adjacent screening elements. Note that changes in the duty cycle result in a change in the intensity of the interference pattern in the far field but not in a change of the spatial intensity distribution thereof.

In preferred embodiments of the invention, the second optical grating comprises one or more screening elements having a length corresponding to a second multiple of half the value of the predefined wavelength other than a first multiple of half the wavelength, wherein the screening elements other than said one or more screening elements have a length corresponding to the first multiple of half the value of the predefined wavelength. The one or more screening elements having the length corresponding to a second multiple of half the value of predefined wavelength do hence not block the light field of extraction light from reaching out towards the exterior of the waveguide structure along the same length as the remaining screening elements. The remaining screening elements block the light field of extraction light from reaching out towards the exterior of the waveguide along a first length that corresponds to the first multiple of half the value of the predefined wavelength. Instead, said one or more screening elements block the light field of the extraction light from reaching out towards the exterior of the waveguide along a second length that corresponds to the second multiple of half the value of the predefined wavelength, thereby introducing a shift in the interference pattern in the far field, as a result of which the interference pattern formed by the constructive interference of the extraction light in the far field may be divided into different parts according to different characteristics of the interference pattern.

For instance, said one or more screening elements may have twice the length of the remaining screening elements. In this case, the second length is longer than the first length by half the value of the predefined wavelength. Consequently, one of said one or more screening elements may cause the interference pattern in the far field to be split into a region in which the light field of the extraction light that contributes to the interference pattern in the far field has a positive amplitude and a region in which the light field of the extraction light that contributes to interference pattern in the far field has a negative amplitude.

In preferred embodiments of the invention, the absorbing grating elements and/or the screening elements are of a metal, preferably any of gold, silver, copper, titanium or platinum, or of a metal-like material, preferably of a highly doped semiconductor.

According to preferred embodiments of the invention, the form of the waveguide structure is any one of an open strip, a ring, an eight-loop, an oval or an open strip that ramifies into two or more ramifications at least at one of the ends of the strip. The term "form" is understood herein in a broad sense referring to the topology of the waveguide structure rather than to its particular shape. For example, an "open strip" refers herein to any open segment having the topology of a simple strip extending between a first end and a second end, which may in particular be straight or curved. A "ring" refers to any closed segment having the topology of a ring, which may have a circular or an irregular form. Analogous considerations apply to all mentioned forms.

The possibility of having a waveguide structure according to the invention having any of the aforementioned forms is a further advantage of the vertical extraction of the extraction light along the extraction direction, which is substantially perpendicular to the propagation direction. The form of the waveguide structure may be chosen according to a desired geometry or symmetry of the interference pattern of the extraction light to be obtained in the far field, for instance under consideration of the requirements with respect to a given practical application of the extracted extraction light.

For instance, a closed form of the waveguide structure, like a ring form, an eight-loop form, or an oval form may be preferred in order to minimise efficiency losses through uncontrolled or unwanted radiation at the ends of the waveguide structure. An open form of the waveguide structure, like a strip form, may be preferred in order to minimise costs and complexity of a manufacturing process of the light source.

Further, a waveguide structure having the form of an open strip that ramifies into two or more ramifications at least at one of the ends of the strip may provide the additional advantage of generating extraction light of as many different wavelengths as ramifications are available. Each of the ramifications may provide for a different configuration of the first optical grating and of the second optical grating, which may or may not extend to the one end of the open strip that does not ramify. For example, an open strip that ramifies into three ramifications at one of the ends of the open strip may comprise three different first optical gratings and three different second optical gratings, wherein one first optical grating and one second optical grating are arranged within one of the ramifications of the waveguide structure, possibly but not necessarily extending to the end of the open strip that does not ramify. This way, the functional combination of the first optical grating and the second optical grating according to the present invention may be exploited in three different ways such as to generate extraction light of the different predefined wavelengths according to three different respective interference patterns in the far field and/or such as to generate in combination a corresponding mixed interference pattern in the far field. In addition, the two or more ramifications of the waveguide structure may be of different lengths, and consequently be compatible with standing waves of different wavelengths.

In preferred embodiments of the invention, the light source further comprises a substrate that supports the waveguide structure. Preferably, the substrate has a thickness between 100 $\mu$m and 1000 $\mu$m, more preferably between 300 $\mu$m and 400 $\mu$m. The substrate may comprise any of InP, GaAs, GaSb, and InAs.

In preferred embodiments of the invention, the light of the predefined wavelength is extracted in said perpendicular direction through an uppermost surface of the waveguide structure. "Uppermost" surface indicates herein that the surface is an outermost surface of the waveguide structure in the direction from the active region to the second optical grating, such that if the extraction direction is e.g. a vertical upward direction, the extraction direction points in a direction from the interior of the waveguide structure towards the uppermost surface. This has the advantage of minimising the optical path of the light of the predefined wavelength exiting the waveguide structure such that losses can be reduced so as to achieve a higher efficiency of extraction.

According to preferred embodiments of the invention, the light of the predefined wavelength is extracted in said perpendicular direction through a lowermost surface of the waveguide structure. "Lowermost" surface indicates herein that the surface is an outermost surface of the waveguide structure in the direction from the second optical grating to the active region, such that if the extraction direction is e.g. a vertical upward direction, the extraction direction points in a direction from the lowermost surface towards the interior of the waveguide structure.

In preferred embodiments of the invention, the predefined wavelength has a frequency between 1 and 10 THz, preferably between 1 and 6 THz.

In preferred embodiments of the invention, at least one of the first wavelength and the second wavelength corresponds to a frequency between 20 THz and 375 THz, preferably between 23 THz and 50 THz. This corresponds to wavelength values for light propagating in vacuum between 0,8 $\mu$m and 15 $\mu$m, preferably between 6 $\mu$m and 13 $\mu$m. Note that the corresponding wavelength values for light propagating within the waveguide structure may be obtained in a straightforward way by properly taking into account the effective refraction index of the waveguide structure.

According to a preferred embodiment of the invention, the waveguide structure further comprises an upper wave cladding structure and/or a lower wave cladding structure. The upper wave cladding structure may be arranged between the active region and the uppermost surface of the waveguide structure and configured for propagating light through the interior of the upper cladding structure. The lower wave cladding structure may be arranged between the active region and the lowermost surface of the waveguide structure and configured for propagating light through the interior of the lower cladding structure. The first optical grating may be arranged between the active region and the upper wave cladding structure and the second optical grating may be arranged on the upper wave cladding structure.

In preferred embodiments of the invention, the light source further comprises a first electrical contact arranged on an upper external surface of the waveguide structure and a second electrical contact arranged on a lower external surface of the waveguide structure, wherein the first electrical contact and the second electrical contact are configured for being connected to an external voltage source to create an electric field within the light source between the first electrical contact and the second electrical contact. Said electric field may be used to pump electrons into the active region of the waveguide structure such as to provide for light amplification by the gain medium in the active region according to the principles of stimulated light amplification. The electrical contacts may be made of any of Ti, Pt, Au, Sb, Cu, Ge and Ni. In some preferred embodiments of the invention, the first electrical contact and the second electrical contact may both be arranged on an upper external surface of the waveguide structure or on a lower external surface of the waveguide structure.

According to preferred embodiments of the invention, at least one of the first electrical contact and the second electrical contact has a thickness between 10 nm and 1000 nm, preferably between 400 nm and 600 nm.

In preferred embodiments of the invention, the first electrical contact is arranged above the upper wave cladding structure and the second electrical contact is arranged below the lower wave cladding structure.

In preferred embodiments of the invention, the active region comprises any of GaAs, AlAs, GaP, InP, InAs, GaSb, AlSb, InSb or any ternary, quaternary or quintary alloy thereof.

In preferred embodiments of the invention, the first optical grating and/or the second optical grating comprise any of GaAs, AlAs, GaP, InP, InAs, GaSb, AlSb, InSb or any ternary, quaternary or quintary alloy thereof and/or the active region is n-doped.

According to preferred embodiments of the invention, the first optical grating is n-doped or p-doped and/or the second optical grating is n-doped or p-doped.

A further aspect of the invention relates to a method of generating light of a predefined wavelength using the light source of any of the embodiments described above. In particular, the method comprises the steps of:

- Amplifying light in the gain medium of the active region;
- Lasing light of the first wavelength and light of the second wavelength and suppressing light of any other wavelengths by means of the first optical grating;
- Determining, by means of the first optical grating:

  ▪ a first spatial phase relationship of the light of the first wavelength, and
  ▪ a second spatial phase relationship of the light of the second wavelength; and

- Extracting light of the predefined wavelength out of the waveguide structure in the extraction direction by means of the second optical grating, wherein said light of the predefined wavelength is produced in the active region from the light of the first wavelength and from the light of the second wavelength by means of difference frequency generation or sum frequency generation.

In a preferred embodiment of the invention, the predefined wavelength corresponds to a frequency in the THz range, preferably to a frequency between 1 THz and 10 THz, more preferably between 1 THz and 6 THz.

A further aspect of the invention relates to a method of manufacturing a light source comprising:

- Forming a waveguide structure defining a propagation direction of light, wherein forming said waveguide comprises:
- Forming an active region in the waveguide structure comprising:

    ▪ a gain medium for amplifying light within said waveguide structure; and
    ▪ a non-linear medium suitable for generating light of a predefined wavelength from light of a first wavelength and from light of a second wavelength by means of difference frequency generation or sum frequency generation, and

- forming a first optical grating configured to ensure lasing of the first wavelength and of the second wavelength and to suppress lasing at any other wavelength to thereby generate light of said first wavelength and light of said second wavelength, wherein said first optical grating is further configured to determine:

    ▪ a first spatial phase relationship of the light of the first wavelength, and
    ▪ a second spatial phase relationship of the light of the second wavelength; and

- forming a second optical grating configured for extracting light of the predefined wavelength out of the waveguide structure in an extraction direction substantially perpendicular to the propagation direction, wherein the second optical grating is arranged relative to the first optical grating such that a constructive interference of the light of said predefined wavelength in the far field is obtained.

In preferred embodiments of the invention, the first optical grating is formed on an upper surface of the active region or within the active region.

According to a preferred embodiment of the invention, the method further comprises forming an upper wave cladding structure arranged between the active region and an uppermost surface of the waveguide structure and configured for propagating light through the interior of the upper wave cladding structure, and forming a lower wave cladding structure arranged between the active region and a lowermost surface of the waveguide structure and configured for propagating light through the interior of the lower wave cladding structure.

In a preferred embodiment of the invention the first optical grating is formed between the active region and the upper wave cladding structure and wherein the second optical grating is formed on the upper wave cladding structure.

In a preferred embodiment of the invention, the method further comprises forming a first electrical contact arranged on an upper external surface of the waveguide structure, and forming a second electrical contact arranged on a lower external surface of the waveguide structure, wherein the first electrical contact and the second electrical contact are configured for being connected to an external voltage source to create an electric field within the light source between the first electrical contact and second electrical contact.

According to a preferred embodiment of the invention, the first electrical contact is formed above the upper wave cladding structure and the second electrical contact is formed below the lower wave cladding structure.

BRIEF DESCRIPTION OF THE DRAWINGS

Fig. 1     shows a layer structure of a light source according to an embodiment of the invention.

Fig. 2     shows the active region, the first optical grating, the second optical grating, and an upper wave cladding structure of a light source according to an embodiment of the invention.

Fig. 3     shows an arrangement of screening elements of the second optical grating in a light source according to the embodiment of the invention of Fig. 2.

Fig. 4     shows a detailed view of the layout of an arrangement of the first optical grating and the second optical grating in a light source according to an embodiment of the invention.

Fig. 5      shows the spatial phase relationship of light of the first wavelength, the light of the second wavelength, the polarization wave, and of the extraction light in a waveguide structure according to the embodiment of Fig. 4.

Fig. 6      shows different possible forms of the waveguide structure of a light source according to different embodiments.

Fig. 7      shows a light source comprising a waveguide having the form of a ring according to an embodiment of the invention

Fig. 8      shows a light source comprising a waveguide having the form of a ring according to an embodiment of the invention.

Fig. 9      shows an illustration of a simulated constructive interference pattern of the extraction light in the far field produced by the light source of Fig. 7.

Fig. 10     shows an illustration of a simulated constructive interference pattern of the extraction light in the far field produced by the light source of Fig. 8.

Fig. 11     shows the layer structure of the light source according to an embodiment of the invention.

DESCRIPTION OF THE PREFERRED EMBODIMENTS

For the purposes of promoting an understanding of the principles of the invention, reference will now be made to a preferred embodiment illustrated in the drawings, and specific language will be used to describe the same. It will nevertheless be understood that no limitation of the scope of the invention is thereby intended, such alterations and further modifications in the illustrated apparatus and such further applications of the principles of the invention as illustrated therein being contemplated as would normally occur now or in the future to one skilled in the art to which the invention relates.

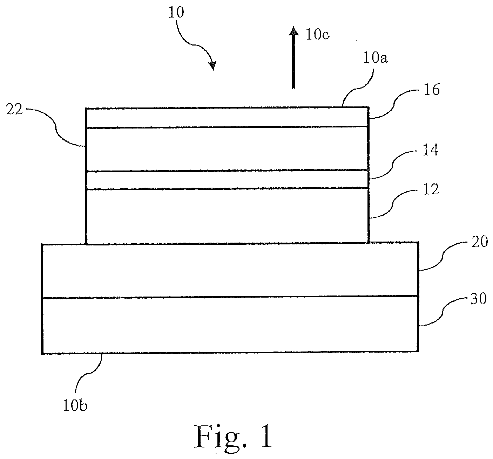

Fig. 1 shows a light source for generating extraction light according to an embodiment of the invention. The light source, which in the embodiment shown corresponds to a semiconductor quantum cascade laser (QCL) light source, comprises a waveguide structure 10 which defines a propagation direction of light. Fig. 1 is a cross-sectional view of the light source showing the layer structure of the waveguide structure 10. The propagation direction of light in Fig. 1 is perpendicular to the paper plane. The waveguide structure comprises an active region 12 that comprises a gain medium for amplifying light and a non-linear medium suitable for generating extraction light from light of a first wavelength and from light of a second wavelength by means of difference frequency generation. In other embodiments of the invention, the non-linear medium may however be suitable for generating extraction light from light of a first wavelength and from light of second wavelength by means of sum frequency generation.

The waveguide structure 10 further comprises a first optical grating 14. The first optical grating 14 is configured to ensure lasing of the first wavelength and of the second wavelength and to suppress lasing at any other wavelength to thereby generate light of the first wavelength and from light of the second wavelength. The first optical grating 14 is further configured to determine a first spatial phase relationship of the light of the first wavelength and a second spatial phase relationship of the light of the second wavelength. In the embodiment shown, the first optical grating 14 is arranged on an upper surface of the active region 12 and is gain/loss coupled with respect to the active region 12.

The waveguide structure 10 further comprises a second optical grating 16 configured for extracting extraction light out of the waveguide structure 10 in an extraction direction. In the embodiment shown, the extraction direction is perpendicular to the propagation direction, such that the extraction light is extracted in the perpendicular direction through the uppermost surface 10a of the waveguide structure 10. Note, however, that in other embodiments the extraction light may be extracted in the perpendicular direction through the lowermost surface 10b of the waveguide structure 10. In Fig. 1, the extraction direction is a vertical direction x indicated by arrow 10c. The second optical grating 16 is arranged relative to the first optical grating 14 such that a constructive interference of the extraction light in the far field is provided.

The waveguide structure 10 further comprises an upper wave cladding structure 22, a lower wave cladding structure 20 and a substrate 30. The upper wave cladding structure 22 is arranged between the active region 12 and an uppermost surface 10a of the waveguide structure 10 and is configured for guiding the propagation of light in the propagation direction. The lower wave cladding structure 20 is arranged between the active region 12 and a lowermost surface 10b of the waveguide structure 10 and is configured for guiding the propagation of light in the propagation direction. The first optical grating 14 is arranged between the active region 12 and the upper wave cladding structure 22. The second optical grating 16 is arranged on the upper wave cladding structure 22. In the embodiment shown, the substrate 30 has a thickness of 350 $\mu$m and supports the remaining components of the waveguide structure 10.

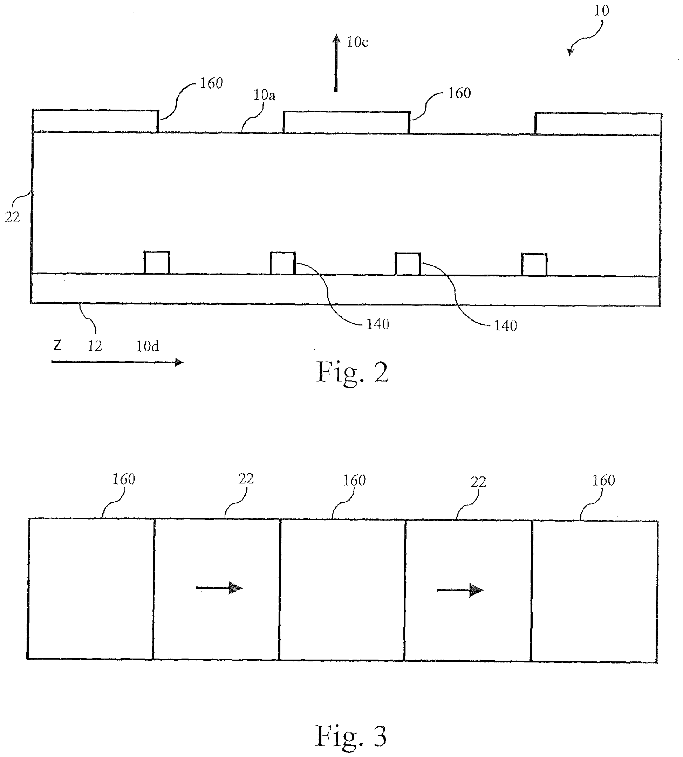

Fig. 2 shows a side view of the waveguide structure 10 of Fig. 1. In Fig. 2, the propagation direction $z$ is in the paper plane and runs from left to right, as indicated by the arrow 10d. The extraction direction coincides in Fig. 2 with the plane of the sheet and runs from bottom to top, as indicated by arrow 10c, such that the extraction light is extracted from the waveguide structure 10 through the uppermost surface 10a thereof.

As shown in Fig. 2, the first optical grating 14 comprises a plurality of absorbing grating elements 140. The absorbing grating elements 140 are configured for fixing the spatial phase relationships of the light of the first wavelength and of the light of the second wavelength. The second optical grating 16 comprises a plurality of screening elements 160. The screening elements 160, which in the embodiment shown are made of gold, are configured for selectively blocking the light field of the extraction light leaving the waveguide structure 10, wherein the location of this selective blocking is defined according to the amplitude value of the extraction light along the extension of the screening elements 160. This is shown in Fig. 3, which corresponds to a top view of the waveguide structure 10 shown in Fig. 2 and illustrates how the screening elements 160 block the light field of the extraction light from reaching out of the waveguide structure 10 while the light field of the extraction light is not blocked from reaching through parts of the upper wave cladding 22 that are exposed between successive screening elements 160. Said parts of the upper wave cladding structure 22 are indicated in the figure by black arrows. Consequently, the amplitude values of the extraction light contributing to the interference pattern in the far field will be those spatially coinciding with the parts of the upper wave cladding 22 and are exposed between successive screening elements 160.

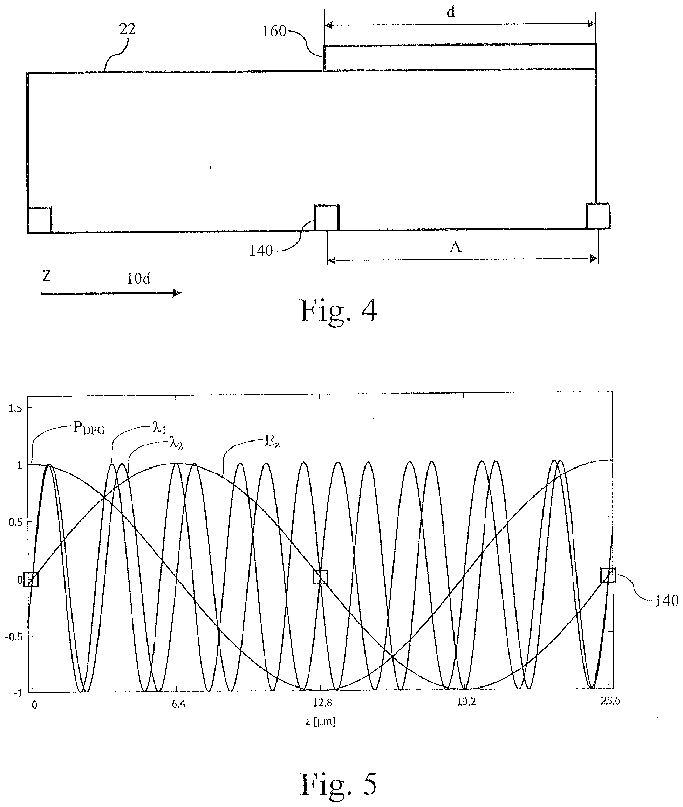

The functional integration of the first optical grating and the second optical grating and the light of the first wavelength and the light of the second wavelength is illustrated in Figs. 4 and 5. Fig. 4 shows a side view of the waveguide structure 10 of figures 1 to 3 showing in detail the spatial arrangement of the absorbing grating elements 140 of the first optical grating 14 and of one of the screening elements 160 of the second optical grating 16.

Fig. 5 shows the spatial phase relationship of light of the first wavelength $\lambda_1$, light of the second wavelength $\lambda_2$, of the part of the polarization wave due to difference frequency generation $P_{DFG}$, and of the light field $E_z$ of extraction light along one period of the light field $E_z$ of extraction light along the propagation direction z, which lies in the paper plane and runs from left to right as indicated by the arrow 10d in Fig. 4. Fig. 4 and Fig. 5 shall be considered in combination. The arrangement of the absorbing grating elements 140 in the waveguide structure 10 along the propagation direction z is characterised by a regular mutual distance $\Lambda$ = 12,8 $\mu$m between each two adjacent absorbing grating elements 140 that corresponds to a first integer multiple m = 9 of half the value of the first wavelength $\lambda_1$ and to a second integer multiple n = 8 of half the value of the second wavelength $\lambda_2$. The location of the absorbing grating elements 140 of the first optical grating 14 is indicated in Fig. 5 by black square boxes.

In the embodiment shown, the absorbing grating elements 140 fix the amplitude value of the light of the first wavelength and of the light of the second wavelength to 0 at those locations of the waveguide structure 10 where the grating elements 140 are arranged. The light of the first wavelength and the light of the second wavelength are in the form of standing waves whose nodes coincide with the locations of the absorbing grating elements 140.

Light is amplified by the gain medium of the active region 12 in a given region of the spectrum, which in the embodiment shown, covers approximately the range between 2,7 $\mu$m and 3,4 $\mu$m. The first optical grating 14 ensures lasing of the first wavelength and of the second wavelength, which in the embodiment shown respectively have values $\lambda_1$ = 2,84 $\mu$m and $\lambda_2$ = 3,2 $\mu$m, and suppresses lasing at any other wavelength. In the embodiment shown, the waveguide structure has an effective refraction index N = 3,2 which may be taken into account for obtaining the corresponding wavelength values for light propagating in vacuum. For instance, the corresponding value of the first wavelength in vacuum is $\lambda_1^{vac} = N\,\lambda_1 = 9,1$ $\mu$m and the corresponding value of the second wavelength in vacuum is $\lambda_2^{vac} = N\,\lambda_2 = 10,24$ $\mu$m. The wavelengths $\lambda_1^{vac}$ and $\lambda_2^{vac}$ correspond to the wavelengths that the light of the first wavelength and the light of the second wavelength would have if they propagated in vacuum. The aforesaid given region of the spectrum in which light is amplified by the gain medium in the active region 12 corresponds to a range of wavelength values for light propagating in vacuum between 8,5 $\mu$m and 11 $\mu$m.

Note that the first wavelength $\lambda_1$ = 2,84 $\mu$m and the second wavelength $\lambda_2$ = 3,2 $\mu$m are the only wavelength values comprised in said given region of the spectrum amplified by the gain medium (2,7 $\mu$m - 3,4 $\mu$m) of the active region 12 that are compatible with the first optical grating, i.e. that can support the formation of standing waves with nodes coinciding with the absorbing grating elements 140. The next neighbouring wavelength values that would be compatible with the first optical grating would correspond to wavelength values given by the condition that the mutual distance $\Lambda$ = 12,8 $\mu$m respectively corresponds to the next integer multiple bigger than the first integer multiple m = 9, namely m = 10, of half the value of the first wavelength $\lambda_1$ and to the next integer multiple smaller than the second integer multiple n = 8, namely n = 7, of half the value of the second wavelength $\lambda_2$. This respectively corresponds to wavelength values of 2,56 $\mu$m for the first wavelength and 3,65 $\mu$m for the second wavelength, which respectively correspond to wavelength values for light propagating in vacuum of 8,2 $\mu$m and 11,7 $\mu$m. Note that these values are not comprised in the region of the spectrum amplified by the gain medium of the active region 12.

The light of the first wavelength and the light of the second wavelength interact by means of difference frequency generation in the active region 12 due to the presence of the non-linear medium and generate a polarization wave according to equation (1) that radiates extraction light, which has a frequency equal to the difference of the frequencies corresponding to the first wavelength and to the second wavelength. Hence, in the embodiment shown, the polarization wave $P_{DFG}$ and the light field $E_z$ of the extraction light have a frequency given by

$$v_{DFG} = \frac{c}{N} \frac{\lambda_2 - \lambda_1}{\lambda_1 \lambda_2} \qquad (2)$$

where $c$ is the speed of light. In the embodiment shown in Fig. 5, the polarization wave and the extraction light have a wavelength of 81,9 $\mu$m (in vacuum), corresponding to a frequency of 3,66 THz. This corresponds to a wavelength value for light propagating within the waveguide structure of 25,2 $\mu$m as can be seen in Fig. 5.

The screening elements 160 of the second optical grating 16 have a length d = 12,8 $\mu$m that coincides with the mutual distance $\Lambda$ between two adjacent absorbing grating elements 140 of the first optical grating 14. Each screening element 160 of the second optical grating 16 extends between two adjacent absorbing grating elements 140 of the first optical grating 14. The screening elements 160 are arranged with respect to the absorbing elements 140 of the first optical grating 14 such that, for instance, the screening element 160 shown in Fig. 4 blocks the light field $E_z$ of the extraction light (more precisely, its electric field component) in spatial regions where the amplitude of the standing waves takes negative values, such that it does not contribute to the constructive interference in the far field. However, the light field $E_z$ of extraction light having a positive amplitude value is not blocked, and can reach through segments of the upper cladding structure 22 that are not covered by screening elements 160, which in the embodiment shown also have a length of 12,8 $\mu$m coinciding with half the wavelength of the extraction light. As a consequence, only extraction light corresponding to the light field $E_z$ of positive amplitude is extracted from the waveguide structure 10 and contributes to the interference pattern in the far field. This way, a possible outbalancing in the interference pattern of positive and negative amplitudes is prevented and the efficiency of the extraction is maximised. In the embodiment shown, the second optical grating 16 has a duty cycle of 50%.

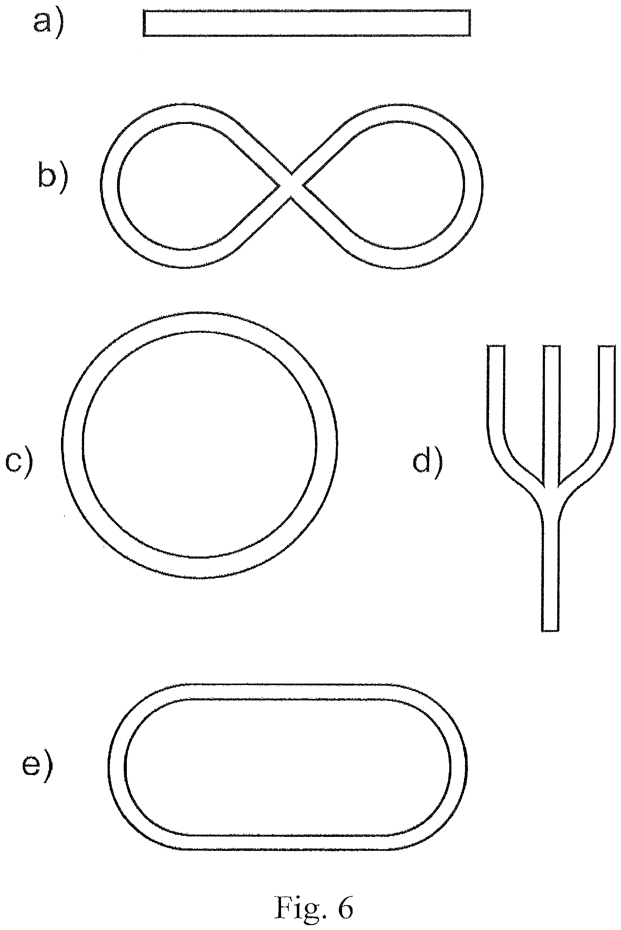

Fig. 6 shows different possible forms of the waveguide structure 10 according to embodiments of the invention. Fig. 6a represents a waveguide structure 10 having the form of an open strip. Fig. 6b represents a waveguide structure 10 having the form of an eight-loop. Fig. 6c represents a waveguide structure 10 having the form of a ring. Fig. 6d represents a waveguide structure 10 having the form of an open strip that ramifies into three ramifications at one end of the strip. Fig. 6e represents a waveguide structure 10 having the form of an oval.

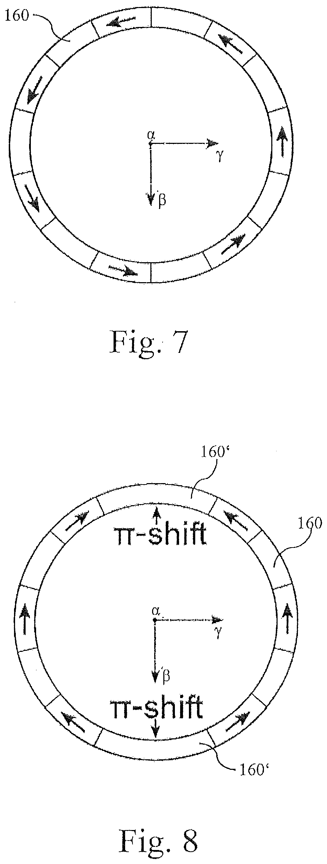

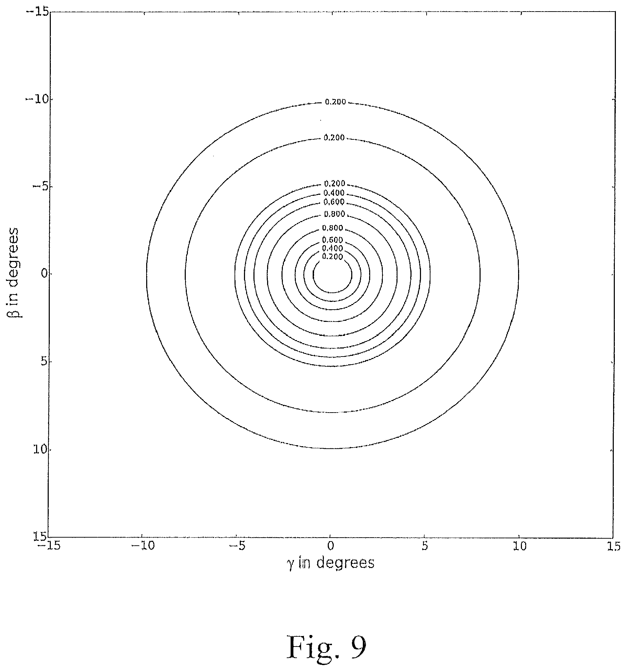

Fig. 7 shows the waveguide structure of a light source according to an embodiment of the invention, wherein the waveguide structure has the form of a ring. In the embodiment shown, the second optical grating is formed by a periodic arrangement of screening elements 160. In this case, the totality of the extraction light that contributes to the interference pattern in the far field corresponds to the light field having a positive amplitude, as indicated by the arrows pointing in the anticlockwise direction. Consequently, a regular interference pattern of the extraction light is obtained in the far field, which is shown in Fig. 9, wherein the contour values in the $\alpha$-direction, which is perpendicular to the paper plane, stand for normalised values of the field intensity of the light field $E_z$ of the extraction light. The interference pattern of Fig. 9 displays rotational symmetry with respect to the centre of the waveguide structure.

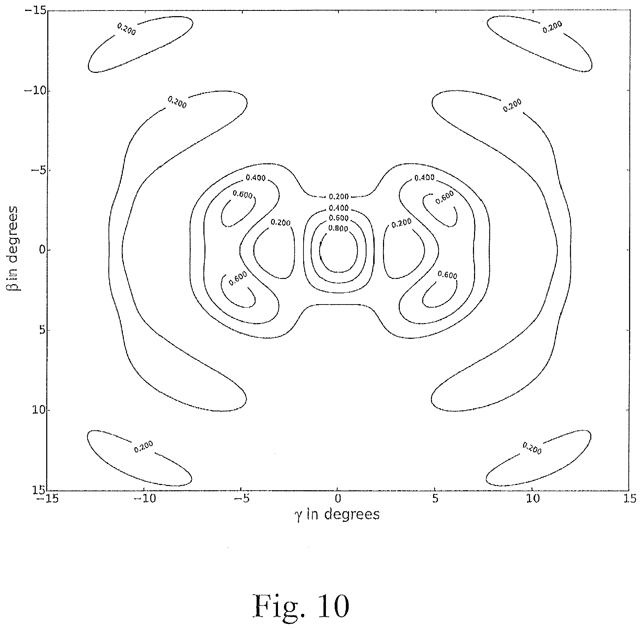

Fig. 8 shows the waveguide structure of a light source according to another embodiment of the invention, wherein the waveguide structure also has the form of a ring, but wherein the second optical grating is formed by an arrangement of screening elements 160 that further comprises two screening elements 160' having twice the length of the remaining screening elements 160, while the gaps between adjacent screening elements 160 are still the same and in each case correspond to half a wavelength of the extraction light. The screening elements 160' split the interference pattern built by the constructive interference of the extraction light in the far field in two parts. A first part is located at one side (e.g. right) of said given screening elements 160' in which the amplitude of the electric field component of the extraction light in the extraction direction (i.e. the light field) has a positive sign. This is indicated in the figure by the arrows pointing in an anticlockwise direction. A second part is located at the other side (e.g. left) of said given screening elements 160' in which the amplitude of the electric field of the extraction light in the extraction direction has a negative sign, which is indicated in the figure by arrows pointing in a clockwise direction. Note that the change of the sign of the amplitude amounts to a shift of $\pi$ in the phase of the electromagnetic field. Consequently, an interference pattern of the extraction light is obtained in the far field, which is shown in Fig. 10, wherein the contour values in the $\alpha$-direction, which is perpendicular to the paper plane, stand for normalised values of the field intensity of the light field Ez of the extraction light. The interference pattern of Fig. 10 displays mirror symmetry with respect to an axis joining the centre of the two screening elements 160'.

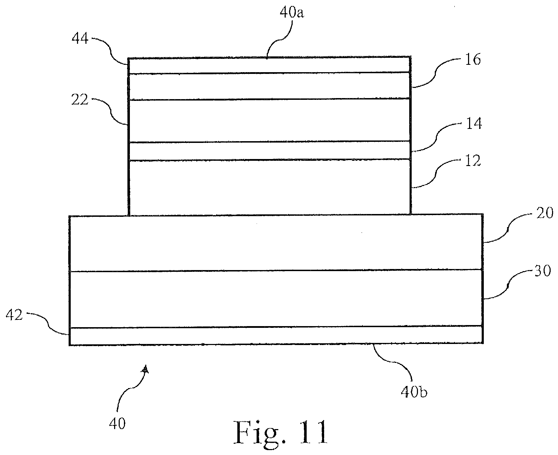

Fig. 11 shows a QCL light source for generating extraction light according to an embodiment of the invention. The light source comprises a waveguide structure 40 that comprises all elements that the waveguide structure 10 of Fig. 1 comprises, which for simplicity are shown in Fig. 11 with the same reference numbers used in Fig. 1. The waveguide structure 40 further comprises a first electrical contact 44 and a second electrical contact 42. The first electrical contact 44 forms an upper external surface 40a of the waveguide structure 40. The second electrical contact 42 forms a lower external surface 40b of the waveguide structure 40. The first electrical contact 44 and the second electrical contact 42 are configured for being connected to an external voltage source to create an electric field within the waveguide structure 40 of the light source between the first electrical contact 44 and the second electrical contact 42, i.e. in a vertical direction with respect to the plane of the sheet. Such an electric field between the electrical contacts 42 and 44 may be used to pump electrons into the active region of the waveguide structure such as to provide for light amplification in the active region by the gain medium.

In the embodiment shown, the first electrical contact 44 and the second electrical contact 42 have a thickness of 50 nm. The first electrical contact 44 is arranged above the upper wave cladding structure 22 and above the second optical grating 16. The second electrical contact 42 is arranged below the lower cladding structure 20 and below the substrate 30.

Although preferred exemplary embodiments are shown and specified in detail in the drawings and the preceding specification, these should be viewed as purely exemplary and not as limiting the invention. It is noted in this regard that only the preferred exemplary embodiments are shown and specified, and all variations and modifications should be protected that presently or in the future lie within the scope of protection of the invention as defined in the claims.

REFERENCE SIGN LIST

| | |
|---|---|
| 10 | waveguide structure |
| 10a | uppermost surface |
| 10b | lowermost surface |
| 10c | extraction direction |
| 10d | propagation direction |
| 12 | active region |
| 14 | first optical grating |
| 16 | second optical grating |
| 20 | lower wave cladding structure |
| 22 | upper wave cladding structure |
| 30 | substrate |
| 40 | waveguide structure |
| 40a | uppermost surface |
| 40b | lowermost surface |
| 42 | second conductive contact |
| 44 | first conductive contact |
| 140 | absorbing grating elements |
| 160 | screening elements |
| 160' | screening elements |

| | |
|---|---|
| $\Lambda$ | regular mutual distance of the absorbing grating elements |
| d | length of the screening elements |
| $\lambda_1$ | first wavelength |
| $\lambda_2$ | second wavelength |
| $P_{DFG}$ | polarisation wave |
| $E_z$ | light field of extraction light |

**Claims**

1. A light source for generating light of a predefined wavelength, comprising:

    a waveguide structure (10) defining a propagation direction (10d) of light, wherein said waveguide structure (10) comprises:

        an active region (12) comprising:

a gain medium for amplifying light within said waveguide structure (10); and

a non-linear medium suitable for generating light of the predefined wavelength from light of a first wavelength and from light of a second wavelength by means of difference frequency generation or sum frequency generation, and

a first optical grating (14) configured to ensure lasing of the first wavelength and of the second wavelength and to suppress lasing at any other wavelength to thereby generate light of said first wavelength and light of said second wavelength, wherein said first optical grating (14) is further configured to determine:

a first spatial phase relationship of the light of the first wavelength, and a second spatial phase relationship of the light of the second wavelength; and

a second optical grating (16) configured for extracting light of the predefined wavelength out of the waveguide structure (10) in an extraction direction (10c) substantially perpendicular to the propagation direction (10d), wherein the second optical grating (16) is arranged relative to the first optical grating (14) such that a constructive interference of the light of said predefined wavelength in the far field is provided.

2. The light source of claim 1, wherein the extraction direction (10c) is perpendicular to the propagation direction (10d) or is at an angle deviating from 90° with respect to the propagation direction (10d) by less than 25°, preferably by less than 15°.

3. The light source of claim 1 or 2, wherein the first optical grating (14) is index-coupled or gain/loss coupled or complex-coupled with respect to the active region (12); and/or wherein the first optical grating (14) is arranged on an upper surface of the active region (12) or within the active region (12); and/or
wherein the first optical grating (14) comprises one of a high order grating, a dual-section grating, and a modulated grating.

4. The light source of any of the preceding claims, wherein the first optical grating (14) comprises an arrangement of one or more absorbing grating elements (140) configured for fixing the spatial phase relationship of the light of the first wavelength and/or the spatial phase relationship of the light of the second wavelength.

5. The light source of any of the preceding claims, wherein the second optical grating (16) comprises one or more screening elements (160), wherein the screening elements (160) are configured for selectively blocking the extraction of light of the predefined wavelength according to a spatial phase relationship of the light of the predefined wavelength.

6. The light source of claims 4 and 5, wherein the arrangement of the absorbing grating elements (140) in the waveguide structure (10) along the propagation direction is **characterised by** a regular mutual distance ($\Lambda$) between two adjacent absorbing grating elements (140) that corresponds to a first integer multiple $m$ of half the value of the first wavelength ($\lambda_1$) and to a second integer multiple $n$ of half the value of the second wavelength ($\lambda_2$), wherein the first integer multiple $m$ and the second integer multiple $n$ are consecutive integer values;
wherein the screening elements (160) preferably have a length (d) that coincides with the mutual distance ($\Lambda$) between two adjacent absorbing grating elements (140) of the first optical grating (14); and
wherein each screening element (160) of the second optical grating (16) preferably extends between two adjacent absorbing grating elements (140) of the first optical grating (14).

7. The light source of claim 6, wherein the screening elements (160) are periodically arranged and the second optical grating (16) has a duty cycle between 20% and 80%, preferably between 30% and 70%, and most preferably between 45% and 55%, wherein the duty cycle is defined as the ratio of a length of the screening elements (160) over a distance between the centers of two adjacent screening elements (160); and/or
wherein the second optical grating (16) comprises one or more screening elements (160') having a length corresponding to a second multiple of half the value of the predefined wavelength other than a first multiple of half the wavelength, wherein the screening elements (160) other than said one or more screening elements (160') have a length corresponding to the first multiple of half the value of the predefined wavelength.

8. The light source of any of claims 4 to 7, wherein the absorbing grating elements (140) and/or the screening elements (160) are made of a metal, preferably any of gold, silver, copper, titanium or platinum, or of a metal-like material, preferably of a highly doped semiconductor.

9. The light source of any of the preceding claims, wherein the form of the waveguide structure (10) is any one of an open strip, a ring, an eight-loop, an oval or an open strip that ramifies into two or more ramifications at least at one of the ends of the strip, and/or
wherein the light of the predefined wavelength is extracted in said perpendicular direction through an uppermost surface (10a) of the waveguide structure (10); and/or wherein the light of the predefined wavelength is extracted in said perpendicular direction through a lowermost surface (10b) of the waveguide structure (10).

10. The light source of any of the preceding claims, wherein the predefined wavelength has a frequency between 1 and 10 THz, preferably between 1 and 6 THz; and/or
wherein at least one of the first wavelength and the second wavelength corresponds to a frequency between 20 THz and 375 THz, preferably between 23 THz and 50 THz; and/or
wherein the waveguide structure (10) further comprises
an upper wave cladding structure (22) arranged between the active region (12) and an uppermost surface (10a) of the waveguide structure (10) and configured for propagating light through the interior of the upper cladding structure (22), and
a lower wave cladding structure (20) arranged between the active region (12) and a lowermost surface (10b) of the waveguide structure (10) and configured for propagating light through the interior of the lower cladding structure (20);
wherein the first optical grating (14) is preferably arranged between the active region (12) and the upper wave cladding structure (22) and wherein the second optical grating (16) is arranged on the upper wave cladding structure (22).

11. The light source of any of the preceding claims, wherein the active region (12) comprises any of GaAs, AlAs, GaP, InP, InAs, GaSb, AlSb, InSb or any ternary, quaternary or quintary alloy thereof and/or wherein the active region (12) is n-doped; and/or
wherein the first optical grating (14) and/or the second optical grating (16) comprise any of GaAs, AlAs, GaP, InP, InAs, GaSb, AlSb, InSb or any ternary, quaternary or quintary alloy thereof; and/or
wherein the first optical grating (14) is n-doped or p-doped and/or wherein the second optical grating (16) is n-doped or p-doped.

12. A method of generating light of a predefined wavelength, using a light source for generating light of a predefined wavelength, the light source comprising:

a waveguide structure (10) defining a propagation direction (10d) of light, wherein said waveguide structure (10) comprises:

an active region (12) comprising:

a gain medium for amplifying light within said waveguide structure (10); and
a non-linear medium suitable for generating light of the predefined wavelength from light of a first wavelength and from light of a second wavelength by means of difference frequency generation or sum frequency generation, and

a first optical grating (14) configured to ensure lasing of the first wavelength and of the second wavelength and to suppress lasing at any other wavelength to thereby generate light of said first wavelength and light of said second wavelength, wherein said first optical grating (14) is further configured to determine:

a first spatial phase relationship of the light of the first wavelength, and
a second spatial phase relationship of the light of the second wavelength; and

a second optical grating (16) configured for extracting light of the predefined wavelength out of the waveguide structure (10) in an extraction direction (l Oc) substantially perpendicular to the propagation direction (10d), wherein the second optical grating (16) is arranged relative to the first optical grating (14) such that a constructive interference of the light of said predefined wavelength in the far field is provided;

wherein the method comprises the steps of:

Amplifying light in the gain medium of the active region (12);
Lasing light of the first wavelength and light of the second wavelength and suppressing light of any other wavelengths by means of the first optical grating (14);
Determining, by means of the first optical grating (14):

a first spatial phase relationship of the light of the first wavelength, and
a second spatial phase relationship of the light of the second wavelength; and Extracting light of the predefined wavelength out of the waveguide structure (10) in the extraction direction (10c) by means of the second optical grating (16), wherein said light of the predefined wavelength is produced in the active region (12) from the light of the first wavelength and from the light of the second wavelength by means of difference frequency generation or sum frequency generation.

13. The method of claim 12, wherein the predefined wavelength corresponds to a frequency in the THz range, preferably to a frequency between 1 THz and 10 THz, more preferably between 1 THz and 6 THz.

14. A method of manufacturing a light source comprising the steps of:

Forming a waveguide structure (10) defining a propagation direction (10d) of light, wherein forming said waveguide structure (10) comprises:

Forming an active region (12) in the waveguide structure (10) comprising:

a gain medium for amplifying light within said waveguide structure (10); and
a non-linear medium suitable for generating light of a predefined wavelength from light of a first wavelength and from light of a second wavelength by means of difference frequency generation or sum frequency generation, and

forming a first optical grating (14) configured to ensure lasing of the first wavelength and of the second wavelength and to suppress lasing at any other wavelength to thereby generate light of said first wavelength and light of said second wavelength, wherein said first optical grating (14) is further configured to determine:

a first spatial phase relationship of the light of the first wavelength, and a second spatial phase relationship of the light of the second wavelength; and

forming a second optical grating (16) configured for extracting light of the predefined wavelength out of the waveguide structure (10) in an extraction direction (10c) substantially perpendicular to the propagation direction (10d), wherein the second optical grating (16) is arranged relative to the first optical grating (14) such that a constructive interference of the light of said predefined wavelength in the far field is obtained.

15. The method of claim 14, wherein the first optical grating (14) is formed on an upper surface of the active region (12) or within the active region (12); and/or
wherein the method further comprises:

forming an upper wave cladding structure (22) arranged between the active region (12) and an uppermost surface (10a) of the waveguide structure (10) and configured for propagating light through the interior of the upper cladding structure (22), and
forming a lower wave cladding structure (20) arranged between the active region (12) and a lowermost surface (10b) of the waveguide structure (10) and configured for propagating light through the interior of the lower cladding structure (20) wherein the first optical grating (14) is preferably formed between the active region (12) and the upper wave cladding structure (22) and wherein the second optical grating (16) is formed on the upper wave cladding structure (22).

Fig. 1

Fig. 2

Fig. 3

Fig. 4

Fig. 5

a)

b)

c)

d)

e)

Fig. 6

160

α
γ
β

Fig. 7

160'

π-shift
160

α
γ
β

π-shift

160'

Fig. 8

Fig. 9

Fig. 10

Fig. 11

| | Europäisches Patentamt European Patent Office Office européen des brevets | **PARTIAL EUROPEAN SEARCH REPORT**<br>under Rule 62a and/or 63 of the European Patent Convention.<br>This report shall be considered, for the purposes of<br>subsequent proceedings, as the European search report | Application Number<br>EP 17 15 8685 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/033536 A1 (FUJITA KAZUUE [JP] ET AL) 2 February 2017 (2017-02-02)<br>* paragraph [0100] - paragraph [0118]; figures 6, 12 *<br>----- | 1-13 | INV.<br>H01S5/10<br>H01S5/06 |
| A | DUNN M H ET AL: "Line-narrowed, compact and coherent source of widely tunable terahertz radiation",<br>INFRARED AND MILLIMETER WAVES, 2007 AND THE 2007 15TH INTERNATIONAL CONFERENCE ON TERAHERTZ ELECTRONICS. IRMMW-THZ. JOINT 32ND INTERNATIONAL CONFERENCE ON, IEEE, PISCATAWAY, NJ, USA,<br>2 September 2007 (2007-09-02), pages 613-616, XP031249752,<br>ISBN: 978-1-4244-1438-3<br>* abstract; figure 1 *<br>----- | 1-13 | |
| A | US 2015/311665 A1 (BELKIN MIKHAIL [US] ET AL) 29 October 2015 (2015-10-29)<br>* figure 2 *<br>----- | 1-13 | TECHNICAL FIELDS SEARCHED (IPC)<br><br>H01S |

## INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

  see sheet C

| Place of search | Date of completion of the search | Examiner |
|---|---|---|
| Munich | 20 September 2017 | Flierl, Patrik |

EPO FORM 1503 03.82 (P04E07)

Europäisches
Patentamt

European
Patent Office

Office européen
des brevets

**INCOMPLETE SEARCH
SHEET C**

Application Number

EP 17 15 8685

Claim(s) completely searchable:
       1-13

Claim(s) not searched:
       14, 15

Reason for the limitation of the search:

In response to the clarification request under Rule 62a the applicant has selected claims 1-13 to be searched. Therefore  the Search Report and the corresponding Search Opinion are established for these claims.

## ANNEX TO THE EUROPEAN SEARCH REPORT
## ON EUROPEAN PATENT APPLICATION NO.

EP 17 15 8685

This annex lists the patent family members relating to the patent documents cited in the above-mentioned European search report.
The members are as contained in the European Patent Office EDP file on
The European Patent Office is in no way liable for these particulars which are merely given for the purpose of information.

20-09-2017

| Patent document cited in search report | | Publication date | Patent family member(s) | | Publication date |
|---|---|---|---|---|---|
| US 2017033536 | A1 | 02-02-2017 | DE 102016213749 A1 | | 02-02-2017 |
| | | | JP 2017033981 A | | 09-02-2017 |
| | | | US 2017033536 A1 | | 02-02-2017 |
| US 2015311665 | A1 | 29-10-2015 | NONE | | |

EPO FORM P0459

For more details about this annex : see Official Journal of the European Patent Office, No. 12/82